# EUROPEAN PATENT APPLICATION

(11) **EP 4 626 193 A1**
(43) Date of publication of application: **01.10.2025**
(21) Application number: 24830572.4
(22) Date of filing: 18.06.2024
(51) Int. Cl.: H10K 30/88, H10K 30/50, H10K 30/40

(54) **PEROVSKITE BATTERY AND ELECTRIC DEVICE**

(30) Priority: 30.06.2023 CN 202310799774
(71) Applicant: Contemporary Amperex Technology Co., Limited, Ningde, Fujian 352100 (CN)
(72) Inventor: LIANG, Weifeng, Ningde, Fujian 352100 (CN); TU, Bao, Ningde, Fujian 352100 (CN); JIA, Boyu, Ningde, Fujian 352100 (CN); GUO, Wenming, Ningde, Fujian 352100 (CN); LUAN, Bo, Ningde, Fujian 352100 (CN); CHANG, Yuhang, Ningde, Fujian 352100 (CN); GUO, Yongsheng, Ningde, Fujian 352100 (CN); OUYANG, Chuying, Ningde, Fujian 352100 (CN)
(74) Representative: Thoma, Michael
(86) International application number: PCT/CN2024/099927
(87) International publication number: WO 2025/001926

(57) **Abstract**

The present application discloses a perovskite battery and an electric device. The perovskite battery includes a substrate; a perovskite layer, where the perovskite layer is disposed on one side of the substrate; a passivation layer, where the passivation layer is disposed on at least one side of the perovskite layer, the passivation layer includes a passivation material, the passivation material includes anions and cations, a volume of the anions is V₁, a volume of the cations is V₂, and V₁ > V₃ > V₂, where V₃ is a volume of a largest defect in the perovskite layer; and an electrode layer, where the electrode layer is disposed on a side of the passivation layer facing away from the perovskite layer.

## Description

### TECHNICAL FIELD

The present application relates to the field of battery technologies, and specifically, to a perovskite battery and an electric device.

### BACKGROUND

Perovskite batteries have attracted widespread attention due to excellent optoelectronic properties such as tunable bandgap, high light absorption coefficient, long carrier lifetime and diffusion length, high defect tolerance, and low-cost low-temperature liquid-phase preparation methods. In just over a decade, the efficiency of perovskite batteries has increased from 3.8% to over 25%, demonstrating significant potential. However, defects are easily generated during the preparation process of perovskite batteries, and the rapid migration of anions at defect sites can affect the long-term stability of the perovskite batteries.

### SUMMARY

In view of the technical problems existing in the background, the present application provides a perovskite battery aimed at hindering the migration of anions in a perovskite layer and improving the long-term stability of the perovskite battery.

According to a first aspect of the present application, a perovskite battery is provided, including: a substrate; a perovskite layer, where the perovskite layer is disposed on one side of the substrate; a passivation layer, where the passivation layer is disposed on at least one side of the perovskite layer, the passivation layer includes a passivation material, the passivation material includes anions and cations, a volume of the anions is V₁, a volume of the cations is V₂, and V₁ > V₃ > V₂, where V₃ is a volume of a largest defect in the perovskite layer; and an electrode layer, where the electrode layer is disposed on a side of the passivation layer facing away from the perovskite layer.

In the perovskite battery provided by the present application, when the passivation layer is disposed between the perovskite layer and the electrode layer, V₁ > V₂, smaller-volume cations in the passivation layer are prone to movement, while larger-volume anions in the passivation layer are difficult to move, forming a potential barrier between the anions and cations in the passivation layer, which can reduce a probability of anions in the perovskite layer passing through the passivation layer; simultaneously, V₁ > V₃, anions in the passivation layer cannot enter the perovskite layer through defect sites, reducing a risk of anions in the passivation layer entering the perovskite layer, forming a region with high negative charge concentration on a surface of the passivation layer close to the perovskite layer, further reducing migration of anions on the surface of the perovskite layer toward the electrode layer, thereby reducing a probability of anions on the surface of the perovskite layer and within the perovskite layer migrating to the electrode layer and reacting with the electrode layer, improving the long-term stability of the perovskite battery; and V₃ > V₂, cations can enter the perovskite layer, compensating for the defects in the perovskite layer, further improving the long-term stability of the perovskite battery. When the passivation layer is disposed between the perovskite layer and the substrate, a probability of anions in the perovskite layer migrating to the substrate can be reduced, further reducing a probability of perovskite decomposition, improving the long-term stability of the perovskite layer.

According to some embodiments of the present application, the number of atoms, other than hydrogen atoms, in one of the anions of the passivation material is 3 to 24, and the number of atoms, other than hydrogen atoms, in one of the cations of the passivation material is 1 to 5. Thus, a volume of anions in the passivation layer is larger than a volume of cations in the passivation layer, forming a potential barrier between anions and cations in the passivation layer to hinder migration of anions in the perovskite layer, reducing a probability of anions in the perovskite layer migrating to the electrode layer and reacting with the electrode layer.

According to some embodiments of the present application, the anions include A₁-R-A₂, where A₁ includes one or more of hydrogen, halogen, benzene ring, heterocyclic ring, or fused ring, R includes one or more of an alkyl chain with 0 to 10 carbons or an alkenyl group with 2 to 10 carbons, and A₂ includes one or more of carboxylate, sulfonate, phosphonate, or borate.

According to some embodiments of the present application, A₁ includes one or more of the benzene ring or the heterocyclic ring.

According to some embodiments of the present application, R includes one or more of an alkyl chain with 2 to 5 carbons or an alkenyl group with 2 to 5 carbons.

According to some embodiments of the present application, A₂ includes one or more of carboxylate, sulfonate, or phosphonate.

According to some embodiments of the present application, the anions include one or more of N element, O element, P element, or S element. Thus, N element, O element, P element, and S element can bind to defects on a surface of the perovskite layer, passivating the defects, reducing non-radiative recombination, and improving the stability of the defects.

According to some embodiments of the present application, the anions include one or more of benzene ring or alkyl group. Thus, benzene ring and alkyl group have strong hydrophobicity, which can reduce a risk of moisture ingress into the perovskite layer and prolong a service life of the perovskite battery.

According to some embodiments of the present application, the cations include one or more of organic cations, Li⁺, Na⁺, K⁺, Rb⁺, or Cs⁺. Thus, the above cations can enter the perovskite layer, compensating for the defects in the perovskite layer.

According to some embodiments of the present application, the organic cations include one or more of methylammonium cation, ethylammonium cation, propylammonium cation, butylammonium cation, pentylammonium cation, hexylammonium cation, formamidinium cation, imidazolium cation, or guanidinium cation.

According to some embodiments of the present application, the cations include methylammonium cation. Thus, this configuration can supplement the methylamine lost in the perovskite layer during heating, reduce the defects in the perovskite layer, and improve the long-term stability of the perovskite battery.

According to some embodiments of the present application, the passivation material includes one or more of methylammonium phenylpropionate, cesium 1-piperidinepropionate, or formamidinium 2-phenylethane-1-sulfonate.

According to some embodiments of the present application, a thickness of the passivation layer is 0.1 nm to 10 nm. Thus, the effect of the passivation layer on electron transport is reduced while migration of anions in the perovskite layer is hindered.

According to some embodiments of the present application, a material of the electrode layer includes one or more of silver, copper, carbon, gold, aluminum, indium tin oxide, aluminum-doped zinc oxide, boron-doped zinc oxide, or indium zinc oxide.

According to some embodiments of the present application, the material of the electrode layer includes copper. Thus, the passivation layer hinders migration of anions in the perovskite layer to the electrode layer, thereby reducing of the reaction between anions in the passivation layer and a copper electrode, reducing a risk of decomposition of the copper electrode.

According to some embodiments of the present application, a material of the perovskite layer includes one or more of PBX₃ or P₂CDX₆, where P includes one or more of organic cations, Li⁺, Na⁺, K⁺, Rb⁺, or Cs⁺; B includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺; C includes one or more of Cs⁺, Ag⁺, K⁺, and Ru⁺; D includes one or more of Bi³⁺, Ni³⁺, Fe³⁺, Cu³⁺, Sb³⁺, or In³⁺; and X includes one or more of Cl⁻, Br⁻, or I⁻.

According to some embodiments of the present application, B includes one or more of Pb²⁺ or Sn²⁺.

According to some embodiments of the present application, C includes Ag⁺.

According to some embodiments of the present application, the perovskite layer includes I⁻.

According to some embodiments of the present application, a bandgap of the perovskite layer is 1.20 eV to 2.30 eV. Thus, most light in the solar spectrum range can be absorbed, effectively converting from ultraviolet to infrared into electrical energy.

According to some embodiments of the present application, a thickness of the perovskite layer is 200 nm to 1000 nm. Thus, the efficiency of the perovskite battery is improved.

According to some embodiments of the present application, the perovskite battery further includes an electron transport layer, and the electron transport layer is disposed between the passivation layer and the electrode layer. Thus, when the perovskite battery is an inverted perovskite battery, migration of anions in the perovskite layer can be hindered, reducing a probability of anions in the perovskite layer migrating to the electrode layer and reacting with the electrode layer, improving the long-term stability of the perovskite battery.

According to some embodiments of the present application, a material of the electron transport layer includes one or more of fullerene and derivatives thereof, tin dioxide and derivatives thereof, or zinc oxide and derivatives thereof. Thus, this configuration improves electron transport capability and improves the efficiency of the perovskite battery.

According to some embodiments of the present application, the perovskite battery further includes a hole transport layer, and the hole transport layer is disposed between the passivation layer and the electrode layer. Thus, when the perovskite battery is a regular perovskite battery, migration of anions in the perovskite layer can also be hindered, reducing a probability of anions in the perovskite layer migrating to the electrode layer and reacting with the electrode layer, improving the long-term stability of the perovskite battery.

According to some embodiments of the present application, a material of the hole transport layer includes one or more of nickel oxide and derivatives thereof, poly[bis(4-phenyl)(2,4,6-trimethylphenyl)amine] and derivatives thereof, poly(3,4-ethylch as poly(3,4-ethylenedioxythiophene)-poly(styrenesulfonate) and derivatives thereof, 2,2',7,7'-tetrakis[N,N-di(4-methoxyphenyl)amino]-9,9'-spirobifluorene and derivatives thereof, or poly-3-hexylthiophene and derivatives thereof. Thus, hole transport capability is improved and the efficiency of the perovskite battery is improved.

According to a second aspect of the present application, an electric device is provided, including the perovskite battery provided by the first aspect of the present application. Thus, the electric device has good long-term stability and a long service life.

Additional aspects and advantages of the present application will be given in part in the following description, part of which will become apparent from the following description or be learned from the practice of the embodiments of the present application.

### BRIEF DESCRIPTION OF DRAWINGS

Persons of ordinary skill in the art can clearly understand various other advantages and benefits by reading the detailed description of the preferred embodiments below. The accompanying drawings are merely intended to illustrate the preferred embodiments and are not intended to limit the present application. In addition, in all the accompanying drawings, the same reference signs represent the same components. In the accompanying drawings:
FIG. 1 is a schematic structural diagram of a perovskite battery according to an embodiment of the present application;
FIG. 2 is a schematic structural diagram of a perovskite battery according to another embodiment of the present application;
FIG. 3 is a schematic structural diagram of a perovskite battery according to another embodiment of the present application;
FIG. 4 is a schematic structural diagram of a perovskite battery according to another embodiment of the present application;
FIG. 5 is a schematic structural diagram of a perovskite battery according to another embodiment of the present application; and
FIG. 6 is a schematic structural diagram of a perovskite battery according to another embodiment of the present application.

Description of reference signs:
1: perovskite battery; 11: perovskite layer; 12: passivation layer; 13: electrode layer; 14: hole transport layer; 15: electron transport layer; and 16: substrate.

### DESCRIPTION OF EMBODIMENTS

The embodiments of the technical solutions of the present application are described in detail below. The following embodiments are merely used to describe the technical solutions in the present application more clearly, and therefore are merely used as examples and do not constitute any limitation on the protection scope of the present application.

Reference to "embodiment" in the present application means that specific features, structures, or characteristics described with reference to some embodiments may be included in at least one embodiment of the present application. The word "embodiment" appearing in various places in the specification does not necessarily refer to the same embodiment or an independent or alternative embodiment that is exclusive of other embodiments. It is explicitly or implicitly understood by persons skilled in the art the embodiments described herein may be combined with other embodiments.

For brevity, this specification specifically discloses only some numerical ranges. However, any lower limit may be combined with any upper limit to form a range not explicitly recorded; any lower limit may be combined with another lower limit to form a range not explicitly recorded; and likewise, any upper limit may be combined with any other upper limit to form a range not explicitly recorded. In addition, each individually disclosed point or individual single numerical value may itself be a lower limit or an upper limit which can be combined with any other point or individual numerical value or combined with another lower limit or upper limit to form a range not expressly recorded.

In the description of some embodiments of the present application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

Unless otherwise defined, all technical and scientific terms used herein shall have the same meanings as commonly understood by persons skilled in the art to which the present application relates. The terms used herein are intended to merely describe the specific embodiments rather than to limit the present application. The terms "include" and "comprise" and any other variations thereof in the specification, claims and brief description of drawings of the present application are intended to cover non-exclusive inclusions.

With the increasing severity of global ecological and energy shortage issues, solar photovoltaic power generation has received widespread attention. As a third-generation new type of solar cell, perovskite batteries have become a rising star in the field of solar cells due to their low cost, simple preparation process, and high efficiency. However, defects are easily formed during the preparation process of perovskite batteries, and due to the high defect tolerance of perovskite batteries, defects have a relatively small impact on the efficiency of perovskite batteries. However, defect sites in the perovskite layer are regions with faster ion movement rates, and anions in the perovskite layer migrate to the electrode layer and react with the electrode layer, leading to decomposition of the electrode layer, and affecting the long-term stability of perovskite batteries.

A perovskite battery provided by the present application, by making a volume of anions in the passivation layer larger than a volume of cations in the passivation layer, a potential barrier is formed in the passivation layer, and migration of anions in the perovskite layer is hindered; simultaneously, to reduce a risk of anions in the passivation layer entering the perovskite layer, a volume of anions in the passivation layer is made larger than a volume of a largest defect in the perovskite layer, thereby reducing a risk of anions in the passivation layer entering the perovskite layer, forming a region with high negative charge concentration on a surface of the passivation layer close to the perovskite layer, further hindering migration of anions in the perovskite layer, reducing a probability of anions in the perovskite layer reacting with the electrode layer, improving the long-term stability of the perovskite battery.

The perovskite battery disclosed in the present application is a photovoltaic cell, and the perovskite battery disclosed in the embodiments of the present application can be used as a power source for an electric apparatus, or assembled into a photovoltaic power generation system and store electrical energy in an energy storage system composed of energy storage batteries. The electric apparatus may include a street lamp, a signal light, an insect-repelling lamp, an electric fan, an electric toy, an electric tool, an electric bicycle, an electric vehicle, a ship, a spacecraft, and the like. The electric toy may include a fixed or mobile electric toy, for example, a game console, an electric toy car, an electric toy ship, and an electric toy airplane. The spacecraft may include an airplane, a rocket, a space shuttle, a spaceship, and the like. The photovoltaic power generation system may include a large-scale ground photovoltaic power generation system, a distributed photovoltaic power generation and building-integrated photovoltaic power generation system, and the like.

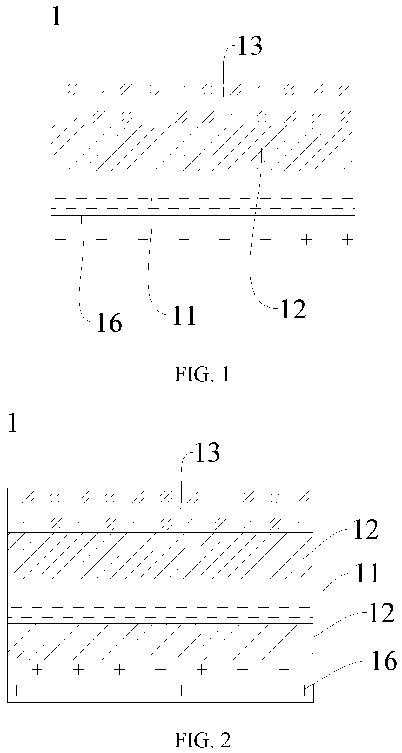

According to a first aspect of the present application, a perovskite battery 1 is provided. Referring to FIG. 1 and FIG. 2, the perovskite battery 1 includes a substrate 16, a perovskite layer 11, where the perovskite layer 11 is disposed on one side of the substrate 16; a passivation layer 12, where the passivation layer 12 is disposed on at least one side of the perovskite layer 11, the passivation layer 12 includes a passivation material, the passivation material includes anions and cations, a volume of the anions is V₁, a volume of the cations is V₂, and V₁ > V₃ > V₂, where V₃ is a volume of a largest defect in the perovskite layer 11; and an electrode layer 13, where the electrode layer 13 is disposed on a side of the passivation layer 12 facing away from the perovskite layer 11. Specifically, the passivation layer 12 may be disposed only between the perovskite layer 11 and the electrode layer 13 (referring to FIG. 1); or the passivation layer 12 is disposed between the perovskite layer 11 and the electrode layer 13 and the passivation layer 12 is disposed between the substrate 16 and the perovskite layer 12 (referring to FIG. 2).

In the perovskite battery 1 provided by the present application, when the passivation layer 12 is disposed between the perovskite layer 11 and the electrode layer 13, V₁ > V₂, smaller-volume cations in the passivation layer 12 are prone to movement, while larger-volume anions in the passivation layer 12 are difficult to move, forming a potential barrier between the anions and cations in the passivation layer 12, which can reduce a risk of anions in the perovskite layer 11 passing through the passivation layer 12; simultaneously, V₁ > V₃, anions in the passivation layer 12 cannot enter the perovskite layer 11 through defect sites, reducing a probability of anions in the passivation layer 12 entering the perovskite layer 11, forming a region with high negative charge concentration on a surface of the perovskite layer 11, further reducing further migration of anions on the surface of the perovskite layer 11, thereby reducing a probability of anions on the surface and within the perovskite layer 11 migrating to the electrode layer 13 and reacting with the electrode layer 13, improving the long-term stability of the perovskite battery 1; V₃ > V₂, cations can enter the perovskite layer, compensating for the defects in the perovskite layer, improving the long-term stability of the perovskite battery 1. When the passivation layer 12 is disposed between the perovskite layer 11 and the substrate 16, a risk of anions in the perovskite layer 11 migrating to the substrate 16 can be reduced, further reducing a probability of perovskite decomposition, improving the long-term stability of the perovskite layer 11.

It should be noted that the passivation layer 12 of the present application may be directly disposed on a surface of the perovskite layer 11, or other functional layers may be disposed between the passivation layer 12 and the perovskite layer 11, as long as the passivation layer 12 is disposed between the electrode layer 13 and the perovskite layer 11.

"Defects" in the present application include defects formed during the crystallization process of perovskite. The "largest defect" in the perovskite layer 11 in the present application refers to a defect with the largest volume in the perovskite layer 11.

According to some embodiments of the present application, the number of atoms in the anions and cations in the passivation material may satisfy a certain range, so that the volume of anions of the passivation layer 12 is greater than the volume of cations of the passivation layer 12. For example, the number of atoms, other than hydrogen atoms, in one of the anions of the passivation material may be 3 to 24. For example, the number may be 3, 5, 8, 11, 14, 17, 20, or 24, or a value within a range defined by any two of these values. The number of atoms, other than hydrogen atoms, in one of the cations of the passivation material may be 1 to 5. For example, the number may be 1, 2, 3, 4, or 5. Thus, the volume of anions in the passivation layer 12 is larger than the volume of cations in the passivation layer 12, forming a potential barrier in the passivation layer 12 to hinder migration of anions in the perovskite layer 11, reducing a risk of anions in the perovskite layer 11 reacting with the electrode layer 13, and improving the long-term stability of the perovskite battery 1. According to some specific embodiments of the present application, the number of atoms, other than hydrogen atoms, in one of the anions of the passivation material may be 8 to 15, and the number of atoms, other than hydrogen atoms, in one of the cations of the passivation material may be 2 to 4.

According to some embodiments of the present application, the anions may include A₁-R-A₂, where A₁ includes one or more of hydrogen, halogen, benzene ring, heterocyclic ring, or fused ring, R includes one or more of an alkyl chain with 0 to 10 carbons or an alkenyl group with 2 to 10 carbons, and A₂ includes one or more of carboxylate, sulfonate, phosphonate, or borate. Thus, the volume of anions in the passivation layer 12 is large, making movement difficult in the passivation layer 12, while small-molecule cations in the passivation layer 12 are prone to movement, anions in the passivation layer 12 and cations in the passivation layer 12 form a potential barrier to hinder migration of anions in the perovskite layer 11. According to some specific embodiments of the present application, A₁ may include one or more of the benzene ring or the heterocyclic ring. According to some specific embodiments of the present application, R may include one or more of an alkyl chain with 2 to 5 carbons or an alkenyl group with 2 to 5 carbons. According to some specific embodiments of the present application, A₂ may include one or more of carboxylate, sulfonate, or phosphonate.

According to some specific embodiments of the present application, the anions may include one or more of N element, O element, P element, or S element. Thus, N element, O element, P element, or S element can bind to defects on a surface of the perovskite layer 11, passivating the defects, reducing non-radiative recombination, and improving the stability of the defects. Simultaneously, N element, O element, P element, or S element have a strong interaction with a material of the perovskite layer 11, preventing volatile components in the perovskite layer 11 from vaporizing during heating, further improving the stability of the perovskite battery 1.

According to some embodiments of the present application, since perovskite materials are sensitive to moisture, poor encapsulation of the perovskite battery 1 may lead to moisture ingress, reducing the performance of the perovskite battery 1, and the anions in the passivation layer 12 may include one or more of benzene ring or alkyl group. Thus, the passivation layer 12 can delay moisture ingress into the perovskite layer 11, thereby prolonging a service life of the perovskite battery 1.

According to some embodiments of the present application, the cations in the passivation layer 12 may include one or more of organic cations, Li⁺, Na⁺, K⁺, Rb⁺, or Cs⁺. Thus, a volume of cations in the passivation layer 12 is small, making movement easy in the passivation layer 12, while large-volume anions in the passivation layer 12 are difficult to move, anions in the passivation layer 12 and cations in the passivation layer 12 form a potential barrier to hinder migration of anions in the perovskite layer 11. Simultaneously, the above cations can enter the perovskite layer 11, compensating for the defects in the perovskite layer 11.

According to some specific embodiments of the present application, the organic cations may include one or more of methylammonium cation, ethylammonium cation, propylammonium cation, butylammonium cation, pentylammonium cation, hexylammonium cation, formamidinium cation, imidazolium cation, or guanidinium cation.

According to some specific embodiments of the present application, methods such as heating are used during the preparation process of the perovskite battery 1, and heating may lead to loss of unstable components in the perovskite layer 11. Therefore, the cations in the passivation layer 12 may include methylammonium cation. Thus, methylammonium cation can enter the perovskite layer 11, supplementing methylamine lost in the perovskite layer 11 during heating, reducing the defects in the perovskite layer 11, and improving the long-term stability of the perovskite battery 1.

According to some embodiments of the present application, the passivation material may specifically include one or more of methylammonium phenylpropionate, cesium 1-piperidinepropionate, or formamidinium 2-phenylethane-1-sulfonate.

According to some embodiments of the present application, a thickness of the passivation layer 12 may be 0.1 nm to 10 nm. For example, the thickness may be 0.1 nm, 1 nm, 2 nm, 3 nm, 4 nm, 5 nm, 6 nm, 7 nm, 8 nm, or 10 nm, or a value within a range defined by any two of these values. Thus, the effect of the passivation layer 12 on electron transport is reduced while migration of anions in the perovskite layer 11 is hindered, and the efficiency of the perovskite battery 1 is improved.

The method for testing thickness in the present application is: testing a cross-section of the battery using a scanning electron microscope to obtain the thickness of the passivation layer 12.

According to some embodiments of the present application, a material of the electrode layer 13 may include one or more of silver, copper, carbon, gold, aluminum, indium tin oxide (ITO), aluminum-doped zinc oxide (AZO), boron-doped zinc oxide (BZO), or indium zinc oxide (IZO). According to some specific embodiments of the present application, the material of the electrode layer 13 may include copper. When the material of the electrode layer 13 includes copper, the passivation layer 12 can hinder migration of anions in the perovskite layer 11, thereby reducing a probability of anions in the perovskite layer 11 migrating to the electrode layer 13 and reacting with copper, improving the long-term stability of the perovskite battery 1.

According to some embodiments of the present application, a material of the perovskite layer 11 may include one or more of PBX₃ or P₂CDX₆, where P includes one or more of organic cations, Li⁺, Na⁺, K⁺, Rb⁺, or Cs⁺; B includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺; C includes one or more of Cs⁺, Ag⁺, K⁺, and Ru⁺; D includes one or more of Bi³⁺, Ni³⁺, Fe³⁺, Cu³⁺, Sb³⁺, or In³⁺; and X includes one or more of Br⁻ or I⁻. For example, the material of the perovskite layer 11 may be CH₃NH₃PbI₃, CH₃NH₃SnI₃, CH₃NH₃PbI₂Br, and CH₃NH₃Pb(I₁₋ₓBrₓ)₃ (where 0 < x < 1). According to some specific embodiments of the present application, B may include one or more of Pb²⁺ or Sn²⁺. According to some specific embodiments of the present application, C may include Ag⁺.

According to some embodiments of the present application, the perovskite layer includes I⁻. When a material of the electrode layer 13 includes copper and the perovskite layer 11 includes I⁻, the passivation layer 12 can hinder migration of I⁻ in the perovskite layer 11, thereby reducing a probability of I⁻ in the perovskite layer 11 migrating to the electrode layer 13 and reacting with copper, improving the long-term stability of the perovskite battery 1.

According to some embodiments of the present application, a bandgap of the perovskite layer 11 may be 1.20 eV to 2.30 eV. For example, the bandgap may be 1.4 eV, 1.6 eV, 1.8 eV, 2.0 eV, 2.2 eV, or 2.3 eV, or a value within a range defined by any two of these values. Thus, the bandgap of the perovskite layer 11 satisfying the above range can absorb most light in the solar spectrum range, effectively converting from ultraviolet to infrared into electrical energy.

According to some embodiments of the present application, a thickness of the perovskite layer 11 may be 200 nm to 1000 nm. For example, the thickness may be 200 nm, 300 nm, 400 nm, 500 nm, 600 nm, 700 nm, 800 nm, 900 nm, and 1000 nm, or a value within a range defined by any two of these values. Thus, a content of active material in the perovskite layer 11 is increased, and the efficiency of the perovskite battery 1 is improved.

According to some embodiments of the present application, the substrate 16 may include one or more of fluorine-doped tin oxide (FTO), ITO, AZO, BZO, or IZO.

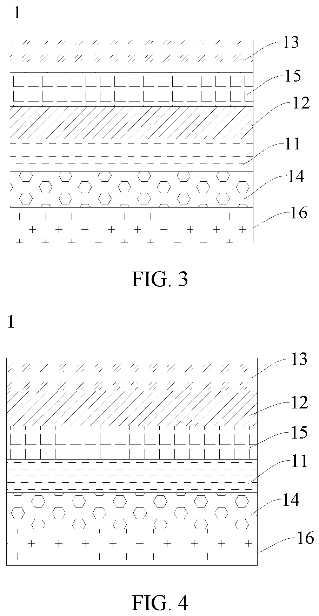

According to some embodiments of the present application, the perovskite battery 1 may be an inverted perovskite battery 1. Specifically, referring to FIG. 3, the perovskite battery 1 further includes an electron transport layer 15, and the electron transport layer 15 is disposed between the passivation layer 12 and the electrode layer 13. For example, the perovskite battery 1 may include a substrate 16; a hole transport layer 14, where the hole transport layer 14 is disposed on one side of the substrate 16; the perovskite layer 11, where the perovskite layer 11 is disposed on a side of the hole transport layer 14 facing away from the substrate 16; the passivation layer 12, where the passivation layer 12 is disposed on a side of the perovskite layer 11 facing away from the hole transport layer 14; the electron transport layer 15, where the electron transport layer 15 is disposed on a side of the passivation layer 12 facing away from the perovskite layer 11; and the electrode layer 13, where the electrode layer 13 is disposed on a side of the electron transport layer 15 facing away from the passivation layer 12. Thus, when the perovskite battery 1 is an inverted perovskite battery 1, migration of anions in the perovskite layer 11 can be hindered, reducing a probability of anions in the perovskite layer 11 migrating to the electrode layer 13 and reacting with the electrode layer 13 and improving the long-term stability of the perovskite battery 1.

According to some embodiments of the present application, referring to FIG. 4, the perovskite battery 1 may further include: the substrate 16; the hole transport layer 14, where the hole transport layer 14 is disposed on one side of the substrate 16; the perovskite layer 11, where the perovskite layer 11 is disposed on a side of the hole transport layer 14 facing away from the substrate 16; the electron transport layer 15, where the electron transport layer 15 is disposed on a side of the perovskite layer 11 facing away from the hole transport layer 14; the passivation layer 12, where the passivation layer 12 is disposed on a side of the electron transport layer 15 facing away from the perovskite layer 11; and the electrode layer 13, where the electrode layer 13 is disposed on a side of the passivation layer 12 facing away from the electron transport layer 15.

According to some embodiments of the present application, a material of the electron transport layer 15 may include one or more of fullerene and derivatives thereof, tin dioxide and derivatives thereof, or zinc oxide and derivatives thereof. According to some specific embodiments of the present application, fullerene derivatives may include one or more of [6,6]-phenyl-C₆₁-butyric acid methyl ester and derivatives thereof or [6,6]-phenyl-C₇₁-butyric acid methyl ester and derivatives thereof. Thus, electron transport capability is improved and the efficiency of the perovskite battery 1 is improved.

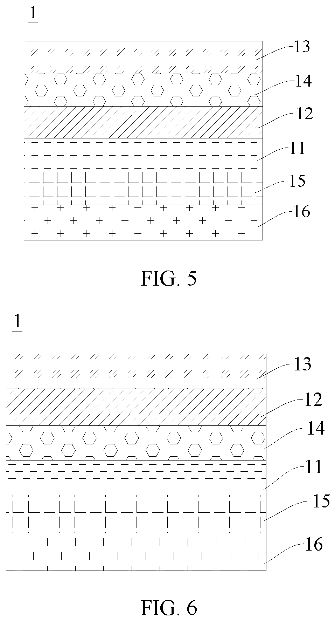

According to some embodiments of the present application, the perovskite battery 1 may also be a regular perovskite battery 1. Specifically, referring to FIG. 5, the perovskite battery 1 may further include the hole transport layer 14, where the hole transport layer 14 is disposed between the passivation layer 12 and the electrode layer 13. For example, the perovskite layer 11 includes the substrate 16; the electron transport layer 15, where the electron transport layer 15 is disposed on one side of the substrate 16; the perovskite layer 11, where the perovskite layer 11 is disposed on a side of the electron transport layer 15 facing away from the substrate 16; the passivation layer 12, where the passivation layer 12 is disposed on a side of the perovskite layer 11 facing away from the electron transport layer 15; the hole transport layer 14, where the hole transport layer 14 is disposed on a side of the passivation layer 12 facing away from the perovskite layer 11; and the electrode layer 13, where the electrode layer 13 is disposed on a side of the hole transport layer 14 facing away from the passivation layer 12. Thus, when the perovskite battery 1 is a regular perovskite battery 1, migration of anions in the perovskite layer 11 can be hindered, reducing a probability of anions in the perovskite layer 11 migrating to the electrode layer 13 and reacting with the electrode layer 13, improving the long-term stability of the perovskite battery 1.

According to some embodiments of the present application, referring to FIG. 6, the perovskite battery 1 may further include: the substrate 16; the electron transport layer 15, where the electron transport layer 15 is disposed on one side of the substrate 16; the perovskite layer 11, where the perovskite layer 11 is disposed on a side of the electron transport layer 15 facing away from the substrate 16; the hole transport layer 14, where the hole transport layer 14 is disposed on a side of the perovskite layer 11 facing away from the electron transport layer 15; the passivation layer 12, where the passivation layer 12 is disposed on a side of the hole transport layer 14 facing away from the perovskite layer 11; and the electrode layer 13, where the electrode layer 13 is disposed on a side of the passivation layer 12 facing away from the hole transport layer 14.

According to some embodiments of the present application, a material of the hole transport layer 14 may include one or more of nickel oxide and derivatives thereof, poly[bis(4-phenyl)(2,4,6-trimethylphenyl)amine] and derivatives thereof, poly(3,4-ethylenedioxythiophene)-poly(styrenesulfonate) and derivatives thereof, 2,2',7,7'-tetrakis[N,N-di(4-methoxyphenyl)amino]-9,9'-spirobifluorene and derivatives thereof, or poly-3-hexylthiophene and derivatives thereof. Thus, hole transport capability is improved and the efficiency of the perovskite battery 1 is improved.

According to some embodiments of the present application, a formation method of the passivation layer 12 may include one or more formations of spin coating, spray coating, blade coating, and slot-die coating, and after the passivation layer 12 is formed, annealing, vacuum, or anti-solvent cleaning may be performed to remove solvent.

According to a second aspect of the present application, an electric device is provided, including the perovskite battery 1 provided by the first aspect of the present application. Thus, the electric device has good long-term stability and a long service life. The electric device may include a lighting element, a display element, a mobile device, and the like, specifically including a street lamp, a signal light, an insect-repelling lamp, an electric fan, an electric toy, an electric tool, an electric bicycle, an electric vehicle, a ship, a spacecraft, and the like. The electric toy may include a fixed or mobile electric toy, for example, a game console, an electric toy car, an electric toy ship, and an electric toy airplane. The spacecraft may include an airplane, a rocket, a space shuttle, a spaceship, and the like. The photovoltaic power generation system may include a large-scale ground photovoltaic power generation system, a distributed photovoltaic power generation and building-integrated photovoltaic power generation system, and the like.

To describe the technical problems solved by the embodiments of the present application, technical solutions, and beneficial effects more clearly, the following further describes the present application in detail with reference to the embodiments and accompanying drawings. Apparently, the described embodiments are only some but not all of these embodiments of the present application. The following description of at least one exemplary example is merely illustrative and definitely is not construed as any limitation on the present application or on use of the present application. All other embodiments obtained by persons of ordinary skill in the art on the basis of the embodiments of the present application without creative efforts shall fall within the protection scope of the present application.

### Example 1

### 1. Preparation of perovskite battery

An FTO conductive glass with dimensions of 2.0 × 2.0 cm was provided, and 0.35 cm of FTO was removed from two ends by laser etching to expose a glass substrate.

The etched FTO conductive glass was ultrasonically cleaned several times sequentially with water, acetone, and isopropanol.

The FTO conductive glass was blown dry with a nitrogen gun to remove solvent and placed in an ultraviolet ozone machine for further cleaning.

Preparation of hole transport layer: The FTO substrate treated with ultraviolet ozone was spin-coated with a 10 mg/mL nickel oxide solution at a speed of 4000 rpm, and annealed on a hot plate at 100°C for 30 minutes to obtain a hole transport layer, where a thickness of the hole transport layer was 20 nm.

Preparation of perovskite layer: Lead iodide, iodoformamidine, cesium iodide, methylammonium bromide, and lead bromide were weighed and dissolved in a mixed solution of N,N-dimethylformamide (DMF) and dimethyl sulfoxide (DMSO), stirred for 3 h, and filtered with a 0.22 µm organic filter membrane to obtain a perovskite precursor solution; the hole transport layer was spin-coated with the perovskite precursor solution at 3000 rpm, annealed at 100°C for 30 min, and cooled to room temperature to obtain a perovskite layer, where an active material of the perovskite layer was Cs_{0.05}FA_{0.78}MA_{0.17}PbI_{2.49}Br_{0.51}, and a thickness of the perovskite layer was 550 nm.

Preparation of passivation layer: A 1 mg/mL isopropanol precursor solution of passivation material 1 was prepared, filtered with a 0.22 µm organic filter membrane, the perovskite layer was spin-coated with the filtered solution at 3000 rpm, and a passivation layer was obtained by annealing, where a thickness of the passivation layer was 1 nm.

Preparation of electron transport layer: The passivation layer was spin-coated with a chlorobenzene solution of (6,6)-phenyl-C₆₁-butyric acid methyl ester (PCBM) with a mass concentration of 20 mg/mL at 1500 rpm, annealed at 100°C for 10 min, and cooled to room temperature, where a thickness of the electron transport layer was 50 nm.

Preparation of hole blocking layer: the electron transport layer was spin-coated with an isopropanol solution of 2,9-dimethyl-4,7-diphenyl-1,10-phenanthroline (BCP) with a mass concentration of 0.5 mg/mL at 5000 rpm, and annealed to obtain a hole blocking layer, where a thickness of the hole blocking layer was 3 nm.

Preparation of electrode layer: Edges were cleared, a suitable mask was selected, the obtained piece was placed in a vapor deposition machine, and a metal electrode Cu was vapor-deposited, where a thickness of the electrode layer was 80 nm, so as to a perovskite battery.

The preparation methods for Examples 1 to 28 and Comparative Examples 1 to 3 were the same as Example 1, with differences from Example 1 detailed in Table 1.

**Table 1**

| | | | | | | | Substrate | Hole transport layer | Perovskite layer | Electron transport layer | Hole blocking layer | Electrode layer |
|---|---|---|---|---|---|---|---|---|---|---|---|---|
| | V₁, V₂, and V₃ | Number of atoms other than hydrogen atoms in anions | Number of atoms other than hydrogen atoms in cations | A₁-R-A₂ | Cation | Thickness (nm) | | | | | | |
| Comparative Example 1 | V₁ < V₂ | 1 | 5 | Chloride ion | Butylammonium cation | 6 | FTO conductive glass | Nickel oxide | Cs_{0.05}FA_{0.78}MA_{0.17}PbI_{2.49}Br_{0.51} | PCBM | BCP | Cu |
| Comparative Example 2 | V₁ < V₃ | 1 | 7 | Chloride ion | Hexylammonium cation | 6 | FTO conductive glass | Nickel oxide | Cs_{0.05}FA_{0.78}MA_{0.17}PbI_{2.49}Br_{0.51} | PCBM | BCP | Cu |
| Comparative Example 3 | V₃ < V₂ | 1 | 8 | Chloride ion | Benzylammonium cation | 6 | FTO conductive glass | Nickel oxide | Cs_{0.05}FA_{0.78}MA_{0.17}PbI_{2.49}Br_{0.51} | PCBM | BCP | Cu |
| Example 1 | V₁ > V₃ > V₂ | 3 | 2 | Formate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 2 | | 7 | 2 | n-Valerate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 3 | | 8 | 2 | 1-Butanesulfonate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 4 | | 12 | 2 | Phenylbutyrate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 5 | | 12 | 2 | 3-(4-Chlorophenyl)propionate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 6 | | 12 | 2 | 2-Phenylethane-1-sulfonate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 7 | | 12 | 2 | Phenylethylphosphate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 8 | | 13 | 2 | 3-(2,4-Dimethylphenyl)propionate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 9 | | 13 | 2 | 3-Phenylglutarate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 10 | | 15 | 2 | 7-Phenylheptanoate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 11 | | 18 | 2 | 10-Phenyldecanoate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 12 | | 19 | 2 | 5-(4-Biphenyl)valerate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 13 | | 22 | 2 | 1-Pyrenebutyrate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 14 | | 23 | 2 | Methyl-tetraethylene glycol-phosphonate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 15 | | 29 | 2 | Methyl-hexaethylene glycol-phosphonate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 16 | | 12 | 1 | Phenylethylphosphate | Cs⁺ | 6 | FTO conductive glass | Nickel oxide | Cs_{0.05}FA_{0.78}MA_{0.17}PbI_{2.49}Br_{0.51} | PCBM | BCP | Cu |
| Example 17 | | 12 | 2 | Phenylethylphosphate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 18 | | 12 | 4 | Phenylethylphosphate | Propylammonium cation | 6 | FTO conductive glass | Nickel oxide | Cs_{0.05}FA_{0.78}MA_{0.17}PbI_{2.49}Br_{0.51} | PCBM | BCP | Cu |
| Example 19 | | 12 | 5 | Phenylethylphosphate | Butylammonium cation | 6 | FTO conductive glass | Nickel oxide | Cs_{0.05}FA_{0.78}MA_{0.17}PbI_{2.49}Br_{0.51} | PCBM | BCP | Cu |
| Example 20 | | 12 | 7 | Phenylethylphosphate | Hexylammonium cation | 6 | FTO conductive glass | Nickel oxide | Cs_{0.05}FA_{0.78}MA_{0.17}PbI_{2.49}Br_{0.51} | PCBM | BCP | Cu |
| Example 21 | | 12 | 2 | Phenylethylphosphate | Methylammonium cation | 0.05 | FTO conductive glass | Nickel oxide | Cs_{0.05}FA_{0.78}MA_{0.17}PbI_{2.49}Br_{0.51} | PCBM | BCP | Cu |
| Example 22 | | 12 | 2 | Phenylethylphosphate | Methylammonium cation | 0.1 | FTO conductive glass | Nickel oxide | Cs_{0.05}FA_{0.78}MA_{0.17}PbI_{2.49}Br_{0.51} | PCBM | BCP | Cu |
| Example 23 | | 12 | 2 | Phenylethylphosphate | Methylammonium cation | 5 | FTO conductive glass | Nickel oxide | Cs_{0.05}FA_{0.78}MA_{0.17}PbI_{2.49}Br_{0.51} | PCBM | BCP | Cu |
| Example 24 | | 12 | 2 | Phenylethylphosphate | Methylammonium cation | 10 | FTO conductive glass | Nickel oxide | Cs_{0.05}FA_{0.78}MA_{0.17}PbI_{2.49}Br_{0.51} | PCBM | BCP | Cu |
| Example 25 | | 12 | 2 | Phenylethylphosphate | Methylammonium cation | 15 | FTO conductive glass | Nickel oxide | Cs_{0.05}FA_{0.78}MA_{0.17}PbI_{2.49}Br_{0.51} | PCBM | BCP | Cu |
| Example 26 | V₁ > V₃ > V₂ | 12 | 2 | Phenylethylphosphate | Methylammonium cation | 6 | FTO conductive glass | Nickel oxide | Cs_{0.05}FA_{0.95}MA_{0.17}PbI_{0.83}Br_{0.17} | PCBM | BCP | Cu |
| Example 27 | V₁ > V₃ > V₂ | 5 | 2 | Acrylate | Methylammonium cation | 6 | FTO conductive glass | Nickel oxide | Cs_{0.05}FA_{0.78}MA_{0.17}PbI_{2.49}Br_{0.51} | PCBM | BCP | Cu |
| Example 28 | V₁ > V₃ > V₂ | 10 | 2 | Benzenesulfonate | Methylammonium cation | 6 | FTO conductive glass | Nickel oxide | Cs_{0.05}FA_{0.78}MA_{0.17}PbI_{2.49}Br_{0.51} | PCBM | BCP | Cu |

### Performance testing:

### 1. Photoelectric conversion efficiency test

An AM 1.5G solar simulator was used to provide 100 mW/cm² illumination, and a four-channel digital source meter (Keithley 2440) was used to measure a volt-ampere characteristic curve of the prepared perovskite battery under illumination to obtain the photoelectric conversion efficiency of the perovskite battery. The photoelectric conversion efficiency of the perovskite battery was tested on the third day and the thirtieth day, with test results shown in Table 2.

**Table 2**

| | Photoelectric conversion efficiency | |
|---|---|---|
| | Third day (%) | Thirtieth day (%) |
| Comparative Example 1 | 14.7 | 10.9 |
| Comparative Example 2 | 16.2 | 13.5 |
| Comparative Example 3 | 15.6 | 12.4 |
| Example 1 | 18.5 | 17.2 |
| Example 2 | 19.2 | 17.8 |
| Example 3 | 19.5 | 18.6 |
| Example 4 | 19.8 | 18.9 |
| Example 5 | 20.3 | 20.1 |
| Example 6 | 20.5 | 18.7 |
| Example 7 | 20.8 | 19.5 |
| Example 8 | 20.6 | 19.8 |
| Example 9 | 20.8 | 19.9 |
| Example 10 | 21.1 | 20.4 |
| Example 11 | 20.8 | 19.7 |
| Example 12 | 19.8 | 18.9 |
| Example 13 | 19.4 | 18.5 |
| Example 14 | 19.1 | 18.2 |
| Example 15 | 18.8 | 17.7 |
| Example 16 | 20.5 | 19.8 |
| Example 17 | 20.8 | 20.0 |
| Example 18 | 20.6 | 20.1 |
| Example 19 | 20.5 | 19.5 |
| Example 20 | 20.3 | 19.0 |
| Example 21 | 20.5 | 19.8 |
| Example 22 | 20.3 | 19.7 |
| Example 23 | 20.8 | 19.8 |
| Example 24 | 20.2 | 19.0 |
| Example 25 | 20.0 | 18.9 |
| Example 26 | 20.1 | 20.2 |
| Example 27 | 20.2 | 19.5 |
| Example 28 | 19.6 | 19.8 |

Conclusion: it can be seen from Table 2 that the perovskite batteries of the present application (Examples 1 to 28) exhibit lower attenuation in photoelectric conversion efficiency on the thirtieth day compared to Comparative Examples 1 to 3, indicating that the perovskite battery provided by the present application has excellent long-term stability.

In conclusion, it should be noted that the foregoing embodiments are merely for describing the technical solutions of the present application rather than for limiting the present application. Although the present application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of the present application. All such modifications and equivalent replacements shall fall within the scope of claims and specification of the present application. In particular, as long as there is no structural conflict, the various technical features mentioned in the embodiments can be combined in any manner. The present application is not limited to the specific embodiments disclosed in this specification, but includes all technical solutions falling within the scope of the claims.

## Claims

1. A perovskite battery, comprising:
a substrate;
a perovskite layer, wherein the perovskite layer is disposed on one side of the substrate;
a passivation layer, wherein the passivation layer is disposed on at least one side of the perovskite layer, the passivation layer comprises a passivation material, the passivation material comprises anions and cations, a volume of the anions is V₁, a volume of the cations is V₂, and V₁ > V₃ > V₂, wherein V₃ is a volume of a largest defect in the perovskite layer; and
an electrode layer, wherein the electrode layer is disposed on a side of the passivation layer facing away from the perovskite layer.

2. The perovskite battery according to claim 1, wherein the number of atoms, other than hydrogen atoms, in one of the anions of the passivation material is 3 to 24, and the number of atoms, other than hydrogen atoms, in one of the cations of the passivation material is 1 to 5.

3. The perovskite battery according to claim 1 or 2, wherein the number of atoms, other than hydrogen atoms, in one of the anions of the passivation material is 8 to 15, and the number of atoms, other than hydrogen atoms, in one of the cations of the passivation material is 2 to 4.

4. The perovskite battery according to any one of claims 1 to 3, wherein the anions comprise A₁-R-A₂, wherein A₁ comprises one or more of hydrogen, halogen, benzene ring, heterocyclic ring, or fused ring, R comprises one or more of an alkyl chain with 0 to 10 carbons or an alkenyl group with 2 to 10 carbons, and A₂ comprises one or more of carboxylate, sulfonate, phosphonate, or borate.

5. The perovskite battery according to claim 4, wherein one or more of the following conditions are satisfied:
A₁ comprises one or more of the benzene ring or the heterocyclic ring;
R comprises one or more of an alkyl chain with 2 to 5 carbons or an alkenyl group with 2 to 5 carbons; and
A₂ comprises one or more of carboxylate, sulfonate, or phosphonate.

6. The perovskite battery according to any one of claims 1 to 5, wherein the anions comprise one or more of N element, O element, P element, or S element.

7. The perovskite battery according to any one of claims 1 to 6, wherein the anions comprise one or more of benzene ring or alkyl group.

8. The perovskite battery according to any one of claims 1 to 7, wherein the cations comprise one or more of organic cations, Li⁺, Na⁺, K⁺, Rb⁺, or Cs⁺.

9. The perovskite battery according to claim 8, wherein the organic cations comprise one or more of methylammonium cation, ethylammonium cation, propylammonium cation, butylammonium cation, pentylammonium cation, hexylammonium cation, formamidinium cation, imidazolium cation, or guanidinium cation.

10. The perovskite battery according to any one of claims 1 to 9, wherein the cations comprise methylammonium cation.

11. The perovskite battery according to any one of claims 1 to 10, wherein the passivation material comprises one or more of methylammonium phenylpropionate, cesium 1-piperidinepropionate, or formamidinium 2-phenylethane-1-sulfonate.

12. The perovskite battery according to any one of claims 1 to 11, wherein a thickness of the passivation layer is 0.1 nm to 10 nm.

13. The perovskite battery according to any one of claims 1 to 12, wherein the perovskite battery satisfies one or more of the following conditions:
a material of the electrode layer comprises one or more of silver, copper, carbon, gold, aluminum, indium tin oxide, aluminum-doped zinc oxide, boron-doped zinc oxide, or indium zinc oxide;
the material of the electrode layer comprises copper;
a material of the perovskite layer comprises one or more of PBX₃ or P₂CDX₆, wherein P comprises one or more of organic cations, Li⁺, Na⁺, K⁺, Rb⁺, or Cs⁺; B comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, and Ni²⁺; optionally, B comprises one or more of Pb²⁺ or Sn²⁺; C comprises one or more of Cs⁺, Ag⁺, K⁺, and Ru⁺; optionally, C comprises Ag⁺; D comprises one or more of Bi³⁺, Ni³⁺, Fe³⁺, Cu³⁺, Sb³⁺, or In³⁺; and X comprises one or more of Cl⁻, Br⁻, or I⁻;
the perovskite layer comprises I⁻;
a bandgap of the perovskite layer is 1.20 eV to 2.30 eV; and
a thickness of the perovskite layer is 200 nm to 1000 nm.

14. The perovskite battery according to any one of claims 1 to 13, further comprising an electron transport layer, wherein the electron transport layer is disposed between the passivation layer and the electrode layer.

15. The perovskite battery according to claim 14, wherein a material of the electron transport layer comprises one or more of fullerene and derivatives thereof, tin dioxide and derivatives thereof, or zinc oxide and derivatives thereof.

16. The perovskite battery according to any one of claims 1 to 15, further comprising a hole transport layer, wherein the hole transport layer is disposed between the passivation layer and the electrode layer.

17. The perovskite battery according to claim 16, wherein a material of the hole transport layer comprises one or more of nickel oxide and derivatives thereof, poly[bis(4-phenyl)(2,4,6-trimethylphenyl)amine] and derivatives thereof, poly(3,4-ethylenedioxythiophene)-poly(styrenesulfonate) and derivatives thereof, 2,2',7,7'-tetrakis[N,N-di(4-methoxyphenyl)amino]-9,9'-spirobifluorene and derivatives thereof, or poly-3-hexylthiophene and derivatives thereof.

18. An electric device, comprising the perovskite battery according to any one of claims 1 to 17.
